# EUROPEAN PATENT APPLICATION

(11) **EP 1 094 438 A1**
(43) Date of publication of application: **25.04.2001**
(21) Application number: 00122614.1
(22) Date of filing: 17.10.2000
(51) Int. Cl.: G09G 3/36

(54) **Active matrix display apparatus and driving method therefor**

(30) Priority: 21.10.1999 JP 29908299
(71) Applicant: Pioneer Corporation, Meguro-ku, Tokyo (JP)
(72) Inventor: Ishizuka, Shinichi, c/o Pioneer Corporation, Tsurugashima-shi, Saitama 350-2288 (JP); Fukuda, Yoshinori, c/o Pioneer Corporation, Tsurugashima-shi, Saitama 350-2288 (JP); Ochi, Hideo, c/o Pioneer Corporation, Tsurugashima-shi, Saitama 350-2288 (JP); Miyaguchi, Satoshi, c/o Pioneer Corporation, Tsurugashima-shi, Saitama 350-2288 (JP); Tsuchida, Masami, c/o Pioneer Corporation, Tsurugashima-shi, Saitama 350-2288 (JP)
(74) Representative: Manitz, Finsterwald & Partner Gbr

(57) **Abstract**

A reverse voltage applying circuit is provided for applying a reverse voltage to light-emitting elements. The reverse voltage is a voltage in a direction opposite to a voltage applied to the light-emitting elements when light is emitted therefrom. The reverse voltage is applied in response to a synchronization timing of an input video signal or turning on of a power supply. Alternatively, a reverse voltage applying period is set in a period in which no video image is displayed. The reverse voltage is applied to the predetermined light-emitting elements in the reverse voltage applying period.

## Description

### BACKGROUND OF THE INVENTION

### 1. Field of the Invention

The present invention relates generally to an active matrix display apparatus and a driving method therefor, and more particularly, to a display apparatus including an active matrix display panel having light-emitting elements such as organic electroluminescence elements.

### 2. Description of the Related Art

A matrix type display including a light-emitting panel is being widely developed. The light-emitting panel includes a plurality of light-emitting elements arranged in a matrix configuration. The light-emitting elements for use in such display panels include, for example, an electroluminescence (EL) element which employs an organic material as a light-emitting layer. The light-emitting luminance can be controlled by a current which flows through the element in the organic EL element. The light-emitting display panels using the organic EL elements may be classified into a simple matrix display panel and an active matrix display panel. The organic EL elements are merely arranged in a matrix configuration in the simple matrix light-emitting panel. On the other hand, a driving device including a transistor is added to each of the organic EL elements arranged in a matrix configuration in the active matrix light-emitting panel. The active matrix light-emitting panel has advantages such that electric power consumption is smaller and an amount of crosstalk between pixels is smaller as compared with those of the simple matrix light-emitting panels and the like and, particularly, is suitable as a display of a large screen or a high precision display.

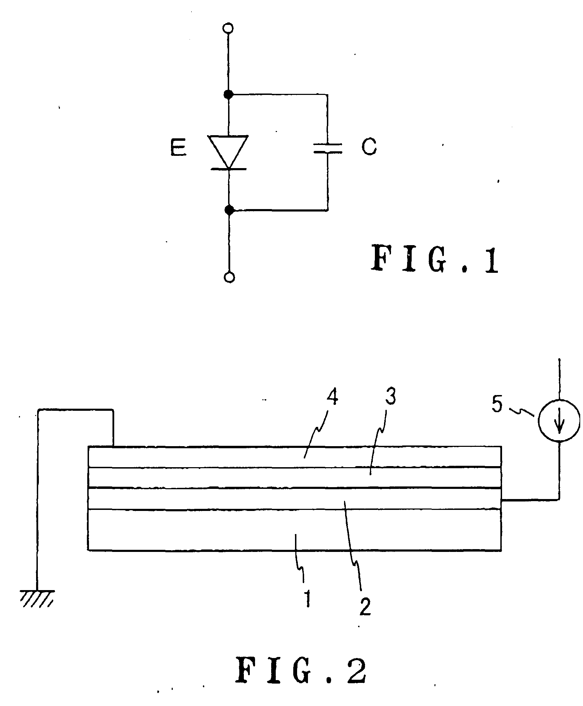

The organic EL element (hereinafter, simply referred to as "EL element") may be represented by a light-emitting element E having a diode characteristic and an electrostatic capacitance C connected in parallel therewith, as an equivalent circuit illustrated in Fig. 1. In particular, the EL element emits light only when a current flows through the light-emitting element E in a forward direction.

The EL element is formed by stacking an anode (transparent electrode) 2, a light-emitting layer 3 including an organic material, and a cathode (metal electrode) 4 on a transparent substrate 1 in this order as illustrated in Fig. 2. When a driving current source 5 is connected to the anode 2 in the forward direction of the EL element and the cathode 4 is connected to the ground, a driving current flows through the light-emitting element 3, thereby causing the EL element to emit light.

### OBJECT AND SUMMARY OF THE INVENTION

The conventional active matrix light-emitting display as mentioned above, however, has a problem of a failure in light emission resulting from a leak current between the cathode and the anode when the formed light-emitting layer has a portion of smaller thickness or when the light-emitting layer is partially absent or lacking so that the anode is in contact with the cathode. Specifically, a thinner portion of the light-emitting layer has a smaller electric resistance than the remaining light-emitting layer to cause a driving current to concentrate in this portion, so that less driving current flows into the remaining normal light-emitting layer to reduce the light-emitting luminance. Such a concentration of current produced in a defectively formed portion of the light-emitting layer also affects other light-emitting elements, resulting in a poor image display on the display apparatus.

It is therefore an object of the present invention to overcome the problem described above and to provide an active matrix display apparatus which is highly reliable and is capable of displaying an excellent image.

According to the present invention, there is provided an active matrix display apparatus comprising a plurality of light-emitting elements located at intersections of scanning lines and data lines arranged in a matrix configuration, driving means for driving each of the plurality of light-emitting elements, display control means for controlling the driving means in accordance with an input video signal, a power supply for supplying power to the plurality of light-emitting elements, and reverse voltage applying means for applying a reverse voltage to the light-emitting elements, the reverse voltage being a voltage in a direction opposite to a voltage applied to the light-emitting elements when emitting light.

According to one aspect of the present invention, the reverse voltage is applied every unit frame corresponding to a synchronization timing of the input video signal.

According to another aspect of the present invention, the display control means includes a timer, and the reverse voltage is applied on the basis of a synchronization timing of the input video signal and an output of the timer.

According to another aspect of the present invention, the reverse voltage is applied in response to powering-on or turning on of the power supply.

According to the present invention, there is provided a method of driving an active matrix display apparatus having a plurality of light-emitting elements located at intersections of scanning lines and data lines arranged in a matrix configuration, a driving circuit for driving each of the plurality of light-emitting elements, display controller for controlling the driving circuit in accordance with an input video signal, and a power supply for supplying power to the plurality of light-emitting elements, the method comprises the step of applying a reverse voltage to the light-emitting elements, the reverse voltage being a voltage in a direction opposite to a voltage applied to the light-emitting elements when emitting light.

According to the present invention, there is provided an active matrix display apparatus comprising a plurality of light-emitting elements located at intersections of scanning lines and data lines arranged in a matrix configuration, driving means for driving each of the plurality of light-emitting elements, display control means for controlling the driving means in accordance with an input video signal, a power supply for supplying power to the plurality of light-emitting elements, setting means for setting a reverse voltage applying period, and reverse voltage applying means for applying a reverse voltage to predetermined light-emitting elements during the reverse voltage applying period, the reverse voltage being a voltage in a direction opposite to a voltage applied to the light-emitting elements when emitting light.

According to the present invention, there is provided a method of driving an active matrix display apparatus having a plurality of light-emitting elements located at intersections of scanning lines and data lines arranged in a matrix configuration, a driving circuit for driving each of the plurality of light-emitting elements, display controller for controlling the driving circuit in accordance with an input video signal, and a power supply for supplying power to the plurality of light-emitting elements, which comprises the steps of setting a reverse voltage applying period; and applying a reverse voltage to predetermined light-emitting elements during the reverse voltage applying period, the reverse voltage being a voltage in a direction opposite to a voltage applied to the light-emitting elements when emitting light.

### BRIEF DESCRIPTION OF THE DRAWINGS

Fig. 1 is a diagram illustrating an equivalent circuit of an EL element;
Fig. 2 is a cross-sectional view schematically illustrating a layer structure of an EL element;
Fig. 3 is a cross-sectional view schematically illustrating a layer structure of an EL element having a defective thickness portion;
Fig. 4 is a cross-sectional view schematically illustrating the shape of the EL element shown in Fig. 3, after it is applied with a reverse voltage;
Fig. 5 is a cross-sectional view schematically illustrating the shape of the EL element shown in Fig. 3, after it is applied with a reverse voltage;
Fig. 6 is a diagram illustrating an example of a circuit configuration corresponding to a pixel in an active matrix display panel;
Fig. 7 is a block diagram showing the configuration of an organic EL display apparatus having an active matrix display panel according to a first embodiment of the present invention;
Fig. 8 is a diagram schematically illustrating a display panel, and a voltage applying circuit/power supply unit connected to a common cathode and a common anode;

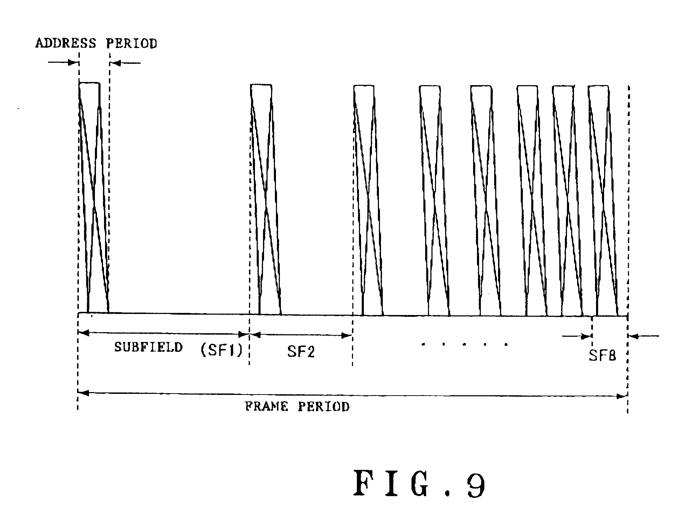

Fig. 9 is a diagram showing the relationship among a frame period, a sub-field period and an address period of a subfield method;
Fig. 10 is a time chart illustrating display control and reverse voltage application control operations executed by a display control unit in the first embodiment of the present invention;
Fig. 11 is a time chart schematically illustrating reverse-voltage application control in an active matrix display panel according to a second embodiment of the present invention; and
Fig. 12 is a diagram illustrating a reset period including a driving circuit ON-period and a reverse-voltage applying period, which is provided out of a video display period.

### DETAILED DESCRIPTION OF THE PREFERRED EMBODIMENTS

Embodiments of the present invention will be described in detail with reference to the accompanying drawings. In the drawings used in the following description, substantially equivalent parts are indicated with the sane reference numerals.

As described above, while a leak current due to short circuit occurs in a portion of a light-emitting layer which is thinner than the remaining light-emitting layer. The inventors of the present application found that this portion can be prevented from short circuiting by applying a light-emitting element with a voltage in the direction opposite to that applied during light emission. The present invention has been made based on this phenomenon. To begin with, the phenomenon will be described with reference to several drawings.

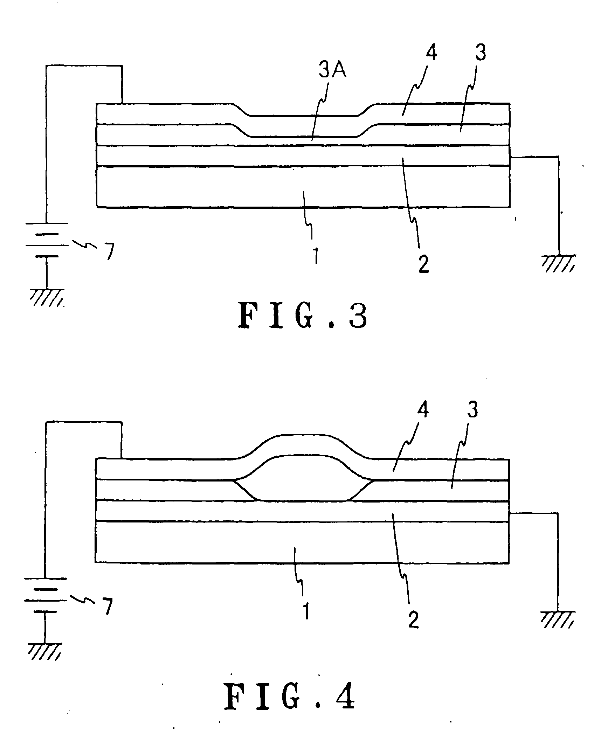

As illustrated in Figs. 3, a light-emitting element comprises an anode (transparent electrode) 2, a light-emitting layer 3 including an organic material, and a cathode (metal electrode) 4 stacked in this order on a transparent substrate 1. The light-emitting layer 3 has a defective region having a smaller thickness, indicated by reference numeral 3A.

Since the light-emitting element has a diode characteristic as described above, no current flows through the light-emitting element even if the normal light-emitting element is applied with a voltage in the direction opposite to that applied thereto during light emission. However, the defective thickness region 3A having a lower resistance, if present, causes a current flow to concentrate into the defective thickness region 3A, so that an excessively larger leak current flows through the defective thickness region 3A than a current flowing therethrough during light emission.

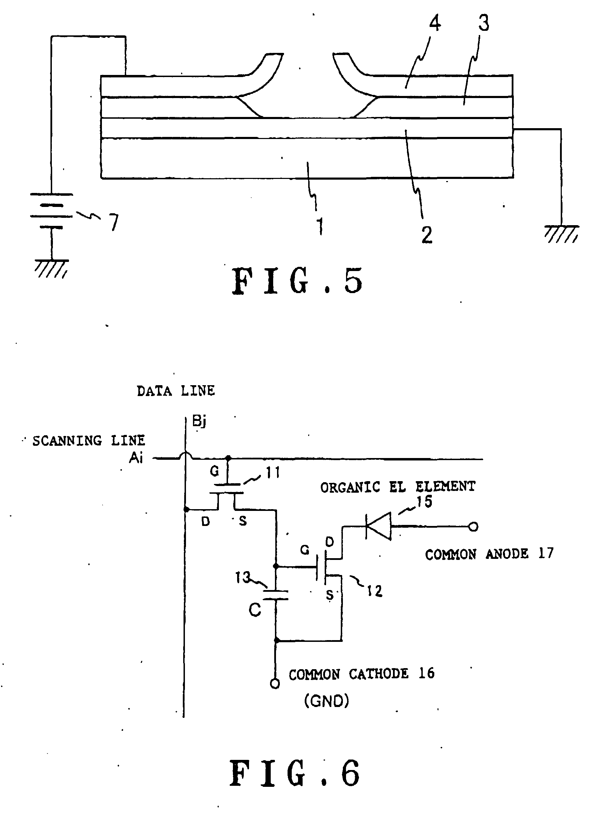

As a result, the defective thickness region 3A and its surrounding light-emitting layer 3 are evaporated, and a resulting expansion pressure causes the cathode 4 to peel off of the anode 2 and swell, as illustrated in Fig. 4. As the cathode 4 further swells, the cathode 4 is broken, and a residual portion of the cathode 4 is bent in a direction away from the anode 2, as illustrated in Fig. 5.

Under the circumstances illustrated in Fig. 4 or 5, light is not emitted from a curved or broken and bent portion of the cathode 4. However, no leak current occurs, since the cathode 4 is separated from the anode 2. Therefore, the rest of the light-emitting element except for the broken portion, and the remaining light-emitting elements normally emit light, so that defective light emission due to a leak current can be avoided.

The defective thickness region 3A of the light-emitting layer may be caused by dust, motes and so on attached on the anode 2 during the manufacturing process. A leak current causing defective light emission may occur, as the driving time passes, depending on the environment in which the display panel is used in addition to the thickness of the defective thickness region.

Fig. 6 illustrates an example of a circuit configuration corresponding to a pixel 10 on an active matrix display panel.

In Fig. 6, an FET (Field Effect Transistor) 11 (transistor for selecting an address) has a gate G connected to an address scanning electrode line (scanning line) through which an address signal is supplied, and a source S connected to a data electrode line (data line) through which a data signal is supplied. The FET 11 has a drain D connected to a gate G of an FET 12 (driving transistor) and also connected to one terminal of a capacitor 13. The FET 12 has a source S connected to the other terminal of the capacitor 13 as well as to a common cathode 16 of the display panel. The common cathode 16 is connected to a ground. The FET 12 has a drain D connected to a cathode of an EL element 15 which has an anode connected to a common anode 17 of the EL element 15 in the display panel.

A light emission control operation of the circuit will be described below. As an ON voltage is supplied to the gate G of the FET 11, the FET 11 passes a current from the source S to the drain D corresponding to a voltage of data supplied to the source S. When an OFF voltage is present at the gate G of the FET 11, the FET 11 is in a so-called cut-off state, in which the drain D of the FET 11 is open. Thus, during a period in which the ON voltage is present at the gate G of the FET 11, the capacitor 13 is charged. The voltage across capacitor 13 is supplied to the gate G of the FET 12, so that a current based on the gate voltage and the source voltage flows into the FET 12 through the EL element 15, thereby causing the EL element 15 to emit light. On the other hand, as the OFF voltage is supplied to the gate G the FET 11, the FET 11 is open, while the FET 12 maintains the voltage at the gate G by a charge accumulated on the capacitor 13 to sustain a driving current to the next scanning, so that light emitted from the EL element 15 is also sustained. It should be noted that since a gate input capacitance exists between the gate G and the source S of the FET 12, a similar operation to the above may be accomplished without the capacitor 13.

The circuit corresponding to one pixel on the display panel which controls the light emission in accordance with the active matrix driving is configured as described above to sustain light emitted from the EL element 15 associated with the pixel, when it is driven. As described above, in the active matrix display panel, the light emission from each light-emitting element is controlled by controlling the driving circuit including the driving element such as an FET.

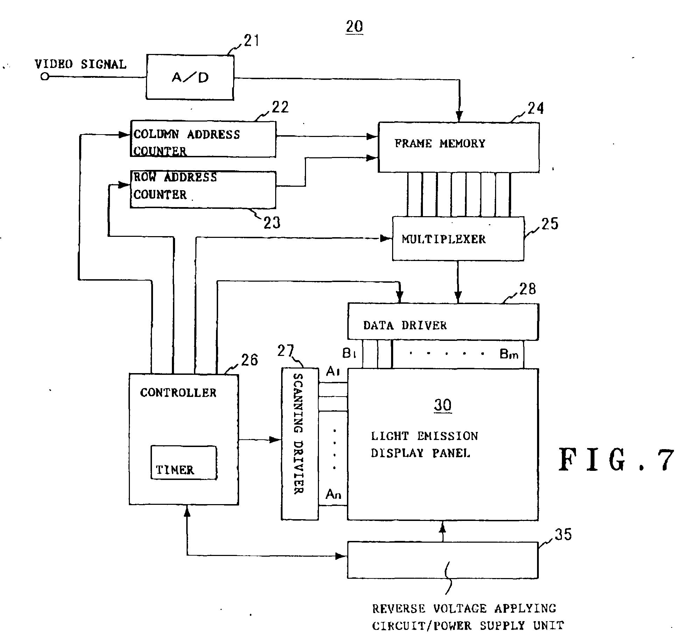

Fig. 7 illustrates the configuration of an organic EL display apparatus 20 having an active matrix display panel according to a first embodiment of the present invention. In Fig. 7, an analog-to-digital (A/D) converter 21 converts an incoming analog video signal to digital video signal data. The digital video signal obtained by the conversion is supplied from the A/D converter 21 to a frame memory 24 to store the digital video signal data in units of frames in the frame memory 24.

A display control unit 26 controls respective components of the organic EL display apparatus 20. The display control unit 26 uses a column address counter 22 and a row address counter 23 to control the digital video signal data stored in the frame memory 24 in accordance with a plurality of subfields having mutually different light-emitting durations as a parameter. The digital video signal data is converted to a plurality of gradation display data (i.e., a number of subfields). The gradation display data is sequentially supplied to a multiplexer 25, together with light emission/non-light emission data corresponding to addresses of the pixels in a light emission display panel 30.

The display control unit 26 also controls to hold column data corresponding to each subfield from among the light emission/non-light emission data supplied to the multiplexer 25 in a data latch circuit (not shown), which is provided in a data driver 28, sequentially from a first row (first scanning line) in an order in which pixels are arranged.

The display control unit 26 supplies the column data of each subfield sequentially held in the data latch circuit to the display panel 30 for each scanning line, and forces EL elements 15 included in a corresponding scanning line to simultaneously emit light by means of a scanning driver 27. The display control unit 26 also contains a timer for controlling a reverse voltage applying circuit/power supply unit 35 connected to a common cathode 16 and a common anode 17 of the display panel 30.

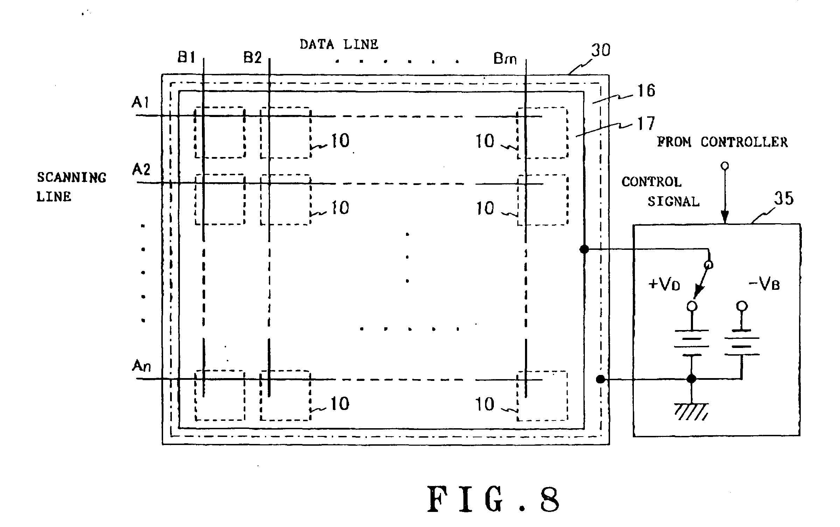

As shown in Fig. 8, the reverse voltage applying circuit/power supply unit 35 comprises a switch circuit, and a power supply for supplying a driving voltage (+V_{D}) and a reverse voltage (-V_{B}) to the EL elements 15, and performs application of the driving voltage and the reverse voltage, which will be described below, to each of the EL elements 15 under the control of the display control unit 26.

As illustrated in Fig, 9, in the embodiment, the luminance gradation is controlled according to a method based on a subfield 2ⁿ gradation method (n=8). Specifically, one frame period in an input video signal is divided into eight subfields (SF1 - SF8), and the luminance in the respective subfield periods (i.e., light-emitting durations T1 - T8 of the respective EL elements 15 in each subfield period) are set such that the ratios of one luminance to the others are 1/2, 1/4, 1/8, 1/16, 1/32, 1/64, 1/128, 1/256 (i.e., 1/2¹ - 1/2⁸) in order, respectively. Then, the EL elements are controlled so that 256 levels of luminance gradation representation can be provided by selectively combining these subfields.

The light emission control for each EL element 15 is performed in each subfield. Specifically, the light emission control is performed for respective column data from the first subfield to the eighth subfield in units of frames. Each EL element 15 on the display panel 30 is controlled to emit light only for a predetermined light-emitting duration in each of the supplied subfields, so that one frame of data can be displayed through light emission in a multi-gradation representation. For reference, an image display apparatus employing the subfield 2ⁿ gradation method is disclosed in Japanese Unexamined Patent publication Kokai No. H10-312173 filed by the same applicant as the present application.

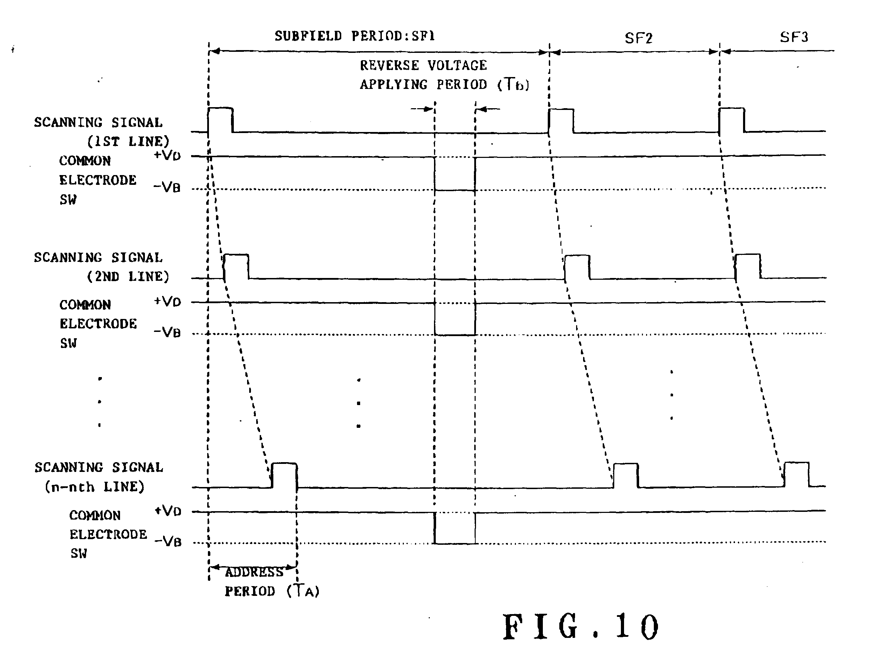

In the following, operations involved in display control and reverse voltage application control, performed by the display control unit 26, will be described in detail with reference to a time chart shown in Fig. 10.

The display control unit 26 controls the voltage applying circuit/power supply unit 35 to apply a driving voltage (+V_{D}) to the common anode 17, and sends a scanning signal (write signal) corresponding to the first subfield (SF1) sequentially from the first scanning line to the n-th scanning line for a-line-at-a-time scanning. In the first subfield period, the EL elements 15 in each scanning line emit light in accordance with the video signal data sent from the data latch circuit in the data driver 28. In other words, light is emitted from the EL elements 15 which locates addresses which are provided with data indicating light emission.

The display control unit 26 controls a switch of the voltage applying circuit/power supply unit 35 to apply a reverse voltage (-V_{B}) to the common anode 17 when a predetermined period of time has elapsed from the time the scanning signal had been sent to all the scanning lines (i.e., at the time the address period expires). After the lapse of a predetermined period (T_{b}) of the reverse voltage application, the display control unit 26 controls the switch from the reverse voltage to the driving voltage to again emit light from the EL elements 15. It should be noted that in this event, the reverse voltage applying period (T_{b}) is set to expire before the second subfield of the first scanning line starts, i.e., before the next scanning signal is sent to the first scanning line.

After the first subfield period of the first scanning line expires, the control display unit 26 sends a scanning signal corresponding to the second subfield (SF2) sequentially from the first scanning line to the n-th scanning line for the a-line-at-a-time scanning in a manner similar to the foregoing. It should be noted that in this embodiment, the reverse voltage is applied only for the first subfield, so that the reverse voltage is not applied in the second to the n-th subfields (SF2 - SFn). In other words, the voltage applying circuit/power supply unit 35 is controlled to apply the reverse voltage only in one subfield period for one frame period.

As described above, the reverse voltage is applied to the light-emitting layer of the display panel to remove defective portions, thereby making it possible to realize an active matrix display apparatus which is highly reliable and is capable of displaying an excellent image.

While the foregoing embodiment has been described for an example in which the reverse voltage is applied within the first subfield period, the reverse voltage may be applied in an arbitrary subfield period not limited to the first subfield period. Also, the reverse voltage may be applied in a plurality of subfield periods as well as in one subfield period. Further, the reverse voltage is not necessarily applied every frame, and instead, the reverse voltage may be applied as appropriate, for example, every several frames.

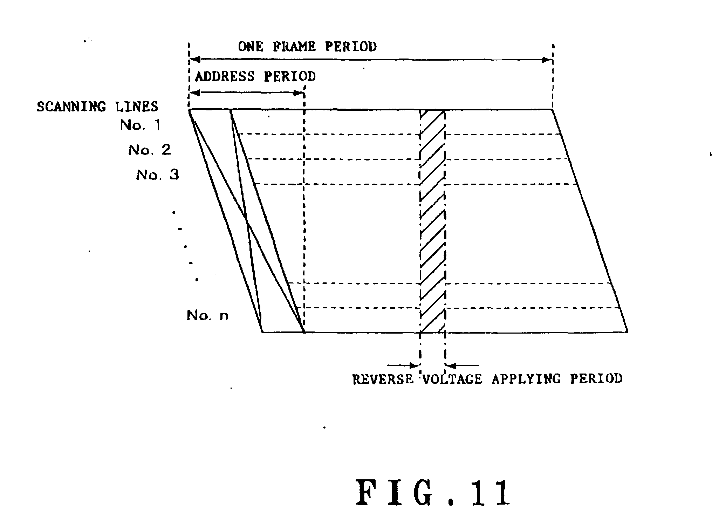

Fig. 11 is a time chart schematically showing the reverse voltage application control in an active matrix display panel 30 according to a second embodiment of the present invention.

The second embodiment differs from the first embodiment in that a method different from the subfield gradation method is employed as the luminance gradation control method. For example, there is a method of controlling the gradation by changing an input signal level of the driving FET as an example of such a method. The present invention can also be applied even if the subfield method is not employed. A reverse voltage applying period can be arbitrarily set within the frame period except for the address period as shown in Fig. 11. It is therefore possible to appropriately adjust the length of the applying period and the frequency of the application as well as the timing of applying the reverse voltage by controlling the reverse voltage applying circuit.

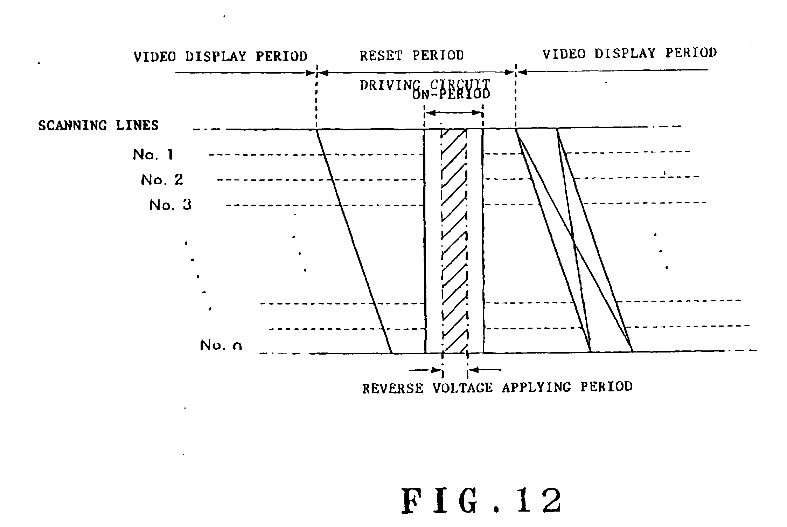

A third embodiment of the present invention will be described below with reference to Fig. 12. Fig. 12 illustrates a reset period which is provided for applying the reverse voltage to the EL elements 15. The reset period is set separate from a video data display period, i.e., in a period in which no video image is displayed.

In the embodiment, the display control unit 26 sets a driving circuit ON-period in a reset period, and a reverse voltage applying period in the driving circuit ON-period. The driving circuit ON-period is a period for making a driving circuit conducting. The driving circuit may include a driving element such as FET for driving each EL element. The reverse voltage applying period in turn is a period in which the common anode 17 is connected to the reverse voltage (-V_{B}), as in the case of the foregoing embodiments. Therefore, the reverse voltage is applied to the EL elements from the power supply unit 35 in a period in which the driving circuit ON-period overlaps with the reverse voltage applying period.

In the embodiment, the display control unit 26 controls the driving FET 12 to be conducting for driving predetermined EL elements and connects the common anode 17 to the reverse voltage to apply the reverse voltage to the predetermined EL elements, so that a defective portion can be removed. The reset period can be provided in an arbitrary period in which a displayed image is not affected, for example, at the time the display apparatus is powered on, at the time an input video channel is switched, or the like. Also, the predetermined EL elements to which the reverse voltage is applied at one time during the reset period may be, for example, EL elements on a predetermined scanning line or data line, or all EL elements within the display panel 30. According to the embodiment, the reverse voltage can be applied to desired EL elements at a desired timing.

While the foregoing embodiments have been described, as an example, for the EL element which has only the light-emitting layer formed between the cathode and the anode, the present invention can also be applied to an EL element which has a function layer such as an electron transport layer, a hole transport layer or the like formed in addition to the light-emitting layer.

Also, while the foregoing embodiments have been described for the organic EL element used as an example, the present invention is not limited to the element but may be applied to a display apparatus which employs other display elements, for example, an inorganic EL element or the like.

Further, the foregoing embodiments are merely illustrative, and may be applied as appropriate in various combinations.

As will be apparent from the forgoing description, the present invention can provide an active matrix display apparatus which is highly reliable and is capable of displaying an excellent image.

The invention has been described with reference to the preferred embodiments thereof. It should be understood by those skilled in the art that a variety of alterations and modifications may be made from the embodiments described above. It is therefore contemplated that the appended claims encompass all such alternations and modifications.

## Claims

1. An active matrix display apparatus comprising:
a plurality of light-emitting elements located at intersections of scanning lines and data lines arranged in a matrix configuration;
driving means for driving each of said plurality of light-emitting elements;
display control means for controlling said driving means in accordance with an input video signal;
a power supply for supplying power to said plurality of light-emitting elements; and
reverse voltage applying means for applying a reverse voltage to said light-emitting elements, said reverse voltage being a voltage in a direction opposite to a voltage applied to said light-emitting elements when emitting light.

2. A display apparatus according to claim 1, wherein said reverse voltage is applied every unit frame corresponding to a synchronization timing of said input video signal.

3. A display apparatus according to claim 1, wherein said display control means includes a timer, and said reverse voltage is applied on the basis of a synchronization timing of said input video signal and an output of said timer.

4. A display apparatus according to claim 1, wherein said reverse voltage is applied in response to turning on of said power supply.

5. A display apparatus according to claim 1, wherein said plurality of EL elements are organic EL elements.

6. A method of driving an active matrix display apparatus having a plurality of light-emitting elements located at intersections of scanning lines and data lines arranged in a matrix configuration, a driving circuit for driving each of said plurality of light-emitting elements, a display controller for controlling said driving circuit in accordance with an input video signal, and a power supply for supplying power to said plurality of light-emitting elements, comprising the step of:
applying a reverse voltage to said light-emitting elements, said reverse voltage being a voltage in a direction opposite to a voltage applied to said light-emitting elements when emitting light.

7. A method according to claim 6, wherein the step of applying a reverse voltage is executed every unit frame corresponding to a synchronization timing of said input video signal.

8. A method according to claim 6, further comprising the step of:
measuring elapsed time from a synchronization timing of said input video signal,
wherein the step of applying a reverse voltage is executed on the basis of the elapsed time.

9. A method according to claim 6, wherein the step of applying a reverse voltage is executed in response to turning on of said power supply.

10. A method according to claim 6, wherein said plurality of EL elements are organic EL elements.

11. An active matrix display apparatus comprising:
a plurality of light-emitting elements located at intersections of scanning lines and data lines arranged in a matrix configuration;
driving means for driving each of said plurality of light-emitting elements;
display control means for controlling said driving means in accordance with an input video signal;
a power supply for supplying power to said plurality of light-emitting elements;
setting means for setting a reverse voltage applying period; and
reverse voltage applying means for applying a reverse voltage to predetermined light-emitting elements during said reverse voltage applying period, said reverse voltage being a voltage in a direction opposite to a voltage applied to said light-emitting elements when emitting light.

12. A display apparatus according to claim 11, wherein said reverse voltage applying period is set in a period in which said input video signal is not displayed.

13. A method of driving an active matrix display apparatus having a plurality of light-emitting elements located at intersections of scanning lines and data lines arranged in a matrix configuration, a driving circuit for driving each of said plurality of light-emitting elements, display controller for controlling said driving circuit in accordance with an input video signal, and a power supply for supplying power to said plurality of light-emitting elements, comprising the steps of:
setting a reverse voltage applying period; and
applying a reverse voltage to predetermined light-emitting elements during said reverse voltage applying period, said reverse voltage being a voltage in a direction opposite to a voltage applied to said light-emitting elements when emitting light.

14. A method according to claim 13, wherein said reverse voltage applying period is set in a period in which said input video signal is not displayed.

15. An active matrix display apparatus comprising:
a plurality of light-emitting elements located at intersections of scanning lines and data lines arranged in a matrix configuration;
a driving circuit for driving each of said plurality of light-emitting elements;
a display controller for controlling said driving circuit in accordance with an input video signal;
a power supply for supplying power to said plurality of light-emitting elements; and
a reverse voltage applying circuit for applying a reverse voltage to said light-emitting elements, said reverse voltage being a voltage in a direction opposite to a voltage applied to said light-emitting elements when emitting light.

16. A display apparatus according to claim 15, wherein said reverse voltage is applied every unit frame corresponding to a synchronization timing of said input video signal.

17. A display apparatus according to claim 15, wherein said display controller includes a timer, and said reverse voltage is applied on the basis of a synchronization timing of said input video signal and an output of said timer.

18. A display apparatus according to claim 15, wherein said reverse voltage is applied in response to turning on of said power supply.

19. A display apparatus according to claim 15, wherein said plurality of EL elements are organic EL elements.
